# EUROPEAN PATENT APPLICATION

(11) **EP 4 773 746 A1**
(43) Date of publication of application: **08.07.2026**
(21) Application number: 25226056.7
(22) Date of filing: 19.12.2025
(51) Int. Cl.: H05K 7/20

(54) **LIQUID MANIFOLD ASSEMBLY FOR ELECTRONICS ENCLOSURE**

(30) Priority: 19.12.2024 US 202463736202 P
(71) Applicant: Hoffman Enclosures Inc., Anoka, MN 55303 (US)
(72) Inventor: DeMars, Allen, Elk River (US)
(74) Representative: Barker Brettell LLP

(57) **Abstract**

A manifold mounting system for an electronics rack can include a manifold assembly (102) and mounting assembly (107). The manifold assembly can include a manifold tube (104) extending between upper and lower ends along a longitudinal axis (118) with first and second walls opposite each other, multiple ports (106) extending from a third wall, and a guide pin (120, 122) extending from the third wall. The mounting assembly can include a bracket for securing the manifold assembly to the electronics rack. The bracket can include a front flange with a slot for receiving the guide pin, opposing side flanges each with at least one aperture, and at least one fastener extending through the apertures and through the first and second walls when mounted.

## Description

### BACKGROUND

In some cooling system applications, a manifold may deliver flows of cooling fluid to and from electronics supported on a rack within a cabinet or stack. For example, some liquid cooling systems can include manifolds that allow pumped fluid to individually cool multiple server trays that are stacked vertically within a server rack or other arrangement. The manifolds can be mounted to the server rack and support the server trays.

### SUMMARY

According to one aspect of the present disclosure, a manifold mounting system for an electronics rack can include a manifold assembly and a mounting assembly. The manifold assembly can include a manifold tube that extends between an upper end and a lower end along a longitudinal axis and includes a first wall and a second wall opposite the first wall. The manifold assembly can include a plurality of ports extending from a third wall of the manifold tube. The manifold assembly can include a guide pin extending from the third wall. The mounting assembly can include a bracket for securing the manifold assembly to the electronics rack. The bracket can include a front flange defining a slot configured to receive the guide pin. The bracket can include opposing side flanges each including at least one aperture. The bracket can include at least one fastener extending through the first wall and the second wall in a mounted configuration, the at least one fastener extending through the at least one aperture in each of the opposing side flanges.

In some examples, the bracket can include two fasteners that are vertically spaced apart in a direction parallel to the longitudinal axis.

In some examples, the bracket can secure the manifold assembly to the electronics rack at the upper end or the lower end.

In some examples, the manifold assembly can further include a second guide pin that extends from a fourth wall of the manifold tube opposite the third wall, in the mounted configuration of the manifold assembly, the second guide pin engaging with a chassis that is mounted to the electronics rack.

In some examples, in the mounted configuration, each of the opposing side flanges can engage one of the first wall or the second wall to clamp the manifold tube between the opposing side flanges.

In some examples, a length of the slot can be at least 10% greater than a diameter of the guide pin.

In some examples, a diameter of the at least one aperture of each of the opposing side flanges can be at least 10% greater than a diameter of the at least one fastener.

In some examples, the guide pin can be a first guide pin, the bracket can be a first bracket at one of the upper end or the lower end, the front flange can be a first front flange including a first slot, the opposing side flanges can be opposing first side flanges, the manifold assembly can further include a second guide pin extending from the third wall, and the mounting assembly can further include a second bracket at the other one of the upper end or the lower end. The second bracket can include a second front flange including a second slot for receiving the second guide pin. The second bracket can include opposing second side flanges each defining at least one aperture. The second bracket can include a second fastener extending the at least one aperture of each of the opposing second side flanges and through the manifold tube from the first wall to the second wall in the mounted configuration.

In some examples, the bracket can be formed as a single piece.

According to another aspect of the present disclosure, a method of mounting a manifold to an electronics rack can include providing a manifold assembly including a manifold tube that extends between an upper end and a lower end along a longitudinal axis. The manifold tube can include a first wall and a second wall opposite the first wall, a plurality of ports extending from a third wall of the manifold tube, and a guide pin extending from the third wall. A bracket can be provided including a front flange having a slot, and opposing side flanges each including at least one aperture. The guide pin can be inserted into the slot of the front flange. The opposing side flanges can be positioned adjacent to the first wall and the second wall of the manifold tube. At least one fastener can be inserted through the at least one aperture of each of the opposing side flanges and through the manifold tube from the first wall to the second wall to secure the manifold to the bracket.

In some examples, a position of the manifold tube can be adjusted relative to the bracket before tightening the at least one fastener.

In some examples, inserting the at least one fastener can include inserting two fasteners that are vertically spaced apart in a direction parallel to the longitudinal axis.

In some examples, positioning the opposing side flanges can include clamping the manifold tube between the opposing side flanges.

In some examples, providing the bracket can include defining one or more of: a length of the slot being at least 10% greater than a diameter of the guide pin; or a diameter of the at least one aperture of each of the opposing side flanges being at least 10% greater than a diameter of the at least one fastener.

In some examples, a second bracket can be provided at an opposite end of the manifold tube from the bracket. The second bracket can include a second front flange having a second slot and opposing second side flanges each including at least one second aperture. A second guide pin extending from the third wall of the manifold tube can be inserted into the second slot of the second front flange. The opposing second side flanges can be positioned adjacent to the first wall and the second wall of the manifold tube. At least one second fastener can be inserted through the at least one second aperture of each of the opposing second side flanges and through the manifold tube from the first wall to the second wall to secure the manifold to the second bracket.

According to yet another aspect of the present disclosure, a mounting assembly for securing a manifold to an electronics rack can include a first bracket configured to secure a first end of the manifold to the electronics rack and a second bracket configured to secure a second end of the manifold to the electronics rack. The first bracket can include a first plurality of flanges including a first slot for receiving a first guide pin of the manifold and a first plurality of apertures. The first bracket can include at least two fasteners extending through the first plurality of apertures and through the manifold, the at least two fasteners being vertically spaced apart. The second bracket can include a second front flange including a second slot for receiving a second guide pin of the manifold and a second plurality of apertures. The second bracket can include at least one fastener extending through the second plurality of apertures and through the manifold.

In some examples, the first bracket can be configured to secure an upper end of the manifold and the second bracket can be configured to secure a lower end of the manifold.

In some examples, each of the first bracket and the second bracket can be formed as a single piece.

In some examples, a diameter of the first plurality of apertures or the second plurality of apertures can be greater than a diameter of the corresponding fastener to allow positional adjustment of the manifold relative to the first bracket or the second bracket.

In some examples, when the manifold is secured to the electronics rack, the at least two fasteners of the first bracket extends through the first plurality of apertures can create a moment connection that resists rotation of the manifold.

This Summary and the Abstract are provided to introduce a selection of concepts in a simplified form that are further described below in the Detailed Description. This Summary is not intended to identify key features or essential features of the claimed subject matter, nor are they intended to be used as an aid in determining the scope of the claimed subject matter.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. Features described in connection with the system or any feature(s) or component(s) described may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate embodiments of the disclosed technology and, together with the description, serve to explain the principles of embodiments of the disclosed technology:
FIG. 1 is an axonometric view of an electronics enclosure according to an embodiment of the disclosed technology.
FIG. 2 is an axonometric view of a manifold assembly of the electronics enclosure of FIG. 1.
FIG.3 is an axonometric view of an electronics enclosure according to an embodiment of the disclosed technology.
FIG. 4 is a partial axonometric view of the manifold assembly of FIG. 3, showing details of a lower bracket assembly.
FIG. 5 is an axonometric view of the lower bracket assembly of FIG. 4.
FIG. 6 is a partial axonometric view of the manifold assembly of FIG. 3, showing details of an upper bracket assembly.
FIG. 7 is an axonometric view of the upper bracket assembly of FIG. 6.
FIG. 8 is an axonometric view of the upper bracket assembly of FIG. 6.

### DETAILED DESCRIPTION

Before any embodiments of the disclosed technology are explained in detail, it is to be understood that the disclosed technology is not limited in its application to the details of construction and the arrangement of components set forth in the following description or illustrated in the following drawings. The disclosed technology is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The following discussion is presented to enable a person skilled in the art to make and use embodiments of the present disclosure. Various modifications to the illustrated embodiments will be readily apparent to those skilled in the art, and the generic principles herein can be applied to other embodiments and applications without departing from embodiments of the present disclosure. Thus, embodiments of the present disclosure are not intended to be limited to embodiments shown but are to be accorded the widest scope consistent with the principles and features disclosed herein. The following detailed description is to be read with reference to the figures, in which like elements in different figures have like reference numerals. The figures, which are not necessarily to scale, depict selected embodiments and are not intended to limit the scope of embodiments of the present disclosure. Skilled artisans will recognize the examples provided herein have many useful alternatives and fall within the scope of embodiments of the present disclosure.

Some of the discussion below describes interfaces between structures of a liquid manifold and an enclosure (e.g., a server rack) that can be used to help provide liquid cooling to server racks. The context and particulars of this discussion are presented as examples only. For example, embodiments of the disclosed technology can be used in other contexts, such as for cooling computing equipment other than servers, or various other electronics, configured in various ways, including with other shapes and arrangements of elements.

When electronic equipment is cooled using liquid coolant, it can be useful to provide blind mate connections and quick connect (e.g., quick disconnect) fittings at interfaces between electrical equipment and other components along a cooling loop (e.g., a liquid manifold). For example, a server or other electronics assembly can be configured to be readily (e.g., partly automatically) aligned for connection to a flow system for liquid cooling of the server or other electronics as the assembly is moved into position for operation. This may allow operators to ensure secure attachment of fluid couplings (e.g., fluid ports of the manifold and the servers) without manual engagement of the couplings or particular attention to alignment of the various components during installation.

A manifold assembly can be mounted to an electronics enclosure (e.g., a server rack) via ancillary mounting features or brackets that are fabricated separately from a fabrication of the manifold assembly. However, individual tolerances of the ancillary mounting features can contribute to tolerance stack up between fluid ports of the manifold assembly and corresponding fluid ports of electrical equipment (e.g., a server tray). In some examples, such ancillary mounting features may require pre-assembly of brackets to the manifold before the manifold is installed into a rack, which can increase assembly complexity and introduce additional tolerance variables. In some cases, a manufacturing tolerance of an electronics enclosure can be different than a manufacturing tolerance of a manifold. Thus, when electrical equipment is inserted into a server rack, a tolerance at an interface between the electrical equipment and the manifold assembly may be tight or the electrical equipment and the manifold assembly may be offset, which can lead to misalignment interfaces of the fluid ports.

In some examples, deformation and tolerance stack-up of a manifold tube can result in misalignment between fluid ports of the manifold and corresponding fluid ports of electrical equipment to be fluidly connected to the liquid manifold. In some examples, misalignment of fluid ports and system deformation (e.g., a change in orientation or position of fluid ports of a liquid manifold relative to fluid ports of electrical equipment) can result in fluid leakage, which can damage electrical equipment and other equipment in a data center, or weak or no fluid connections.

Considerations beyond dimensional variation can also complicate the task of achieving secure and predictable connections at fluid couplings for liquid cooling. For example, pressure of fluid flow at fluid couplings can tend to urge the couplings to separate, with corresponding forces on associated manifolds and electronics enclosures (e.g., racks). In some examples, the pressure of fluid flow can produce a moment reaction force or a torque, which can rotate the manifold relative to the electronic racks and urge the couplings to separate. Additionally, many quick-connect couplings include spring-loaded components, which can exert a substantial amount of spring forces on manifolds and electronics racks. In particular, spring forces that are exerted on non-locking connections may not be absorbed by locking devices during system operation. In this regard, for example, some manifolds may be subject to lateral loading of 800 pounds or more during operation. Such loading can also create (or exacerbate) problems with misalignment of components.

Conventional manifold mounting systems can include a fully floating or conventionally mounted and fully indexed mounting approaches. In fully floating mounting system, a manifold may not be directly attached to a rack and may be positioned locally at a chassis level where electrical equipment connects, providing limited mechanical support from the rack structure. In a conventionally mounted and fully indexed mounting system, a manifold may be rigidly fixed to a rack at all mounting features with tight alignment features at each connection point, which may provide limited accommodation for tolerance variations between the rack and other reference structures.

It can therefore be advantageous to provide improved systems and methods for achieving alignment between fluid ports of a manifold tube and corresponding fluid ports of electrical equipment. Examples of the disclosed technology can provide improvements in this regard, and various others as further detailed below. In particular, some embodiments of the disclosed technology can provide configurations of electronics enclosures and associated structures that allow for improved, simplified methods of installing manifold assemblies to the electronics enclosure. In some examples, manifold mounting systems can be configured as semi-floating mounting systems that include features that address tolerance stack-up challenges, simplify assembly processes, and provide improved resistance to operational loads.

Mounting systems for manifolds mounted to enclosures (e.g., racks) can include locating features to ensure a correct alignment of the ports of a manifold when the manifold is mounted to a rack. In some examples, however, a variance in dimensions between racks can result in a misalignment of ports of a manifold when a manifold is fixedly mounted to a rack. Further, reference features (e.g., structures that interface with structures of the manifold to ensure correct alignment and position of the manifold) can be configured as structures mounted to a rack, such as a chassis. The position of such reference features can vary from rack to rack due to manufacturing tolerances, and, correspondingly, it can be beneficial to provide variability in mounting position of a manifold relative to a rack. This variability can allow a manifold to be positioned and aligned relative to the reference features while accommodating dimensional variations in the rack itself.

In some examples, bracket assemblies can be provided to adjustably mount manifold assemblies to electronics enclosures. In particular, fasteners or indexing features can be provided to ensure an alignment and relative positioning between the bracket assemblies and the manifold assemblies and either or both of the electronics enclosures and a reference feature (e.g., a chassis) mounted to the electronics enclosure. In this regard, it can be beneficial to provide bracket assemblies for mounting a manifold relative to an electronics enclosure, with the bracket assemblies allowing for variability along one or more directions (e.g., a depth direction, height direction, or lateral direction).

According to the present disclosures, bracket assemblies can allow a manifold to be placed at various locations within a tolerance zone before final tightening to accommodate variations in rack dimensions or chassis positioning. In particular, a manifold can be positioned at one of a range of allowable positions along a given direction (e.g., along one of a range of acceptable depths), and an operator can fix the position of the manifold at the desired position by tightening a clamp portion of a manifold bracket to secure the manifold in place. In some examples, the bracket assemblies can include oversized or elongated apertures that allow for positional adjustments of fasteners or indexing features in multiple axes, including in height, lateral, or depth directions, before final tightening of the fasteners. For example, a position of manifold assemblies can be adjusted (e.g., fine-tuned) relative to bracket assemblies before tightening the fasteners in place to fix the manifold at the adjusted position.

In some examples, one or more fasteners can extend an entire way through a manifold tube from one lateral wall to an opposite lateral wall, which can improve mechanical stiffness at an interface between bracket assemblies and manifold assemblies and can provide improved resistance to rotation under operational loads. In some examples, multiple fasteners can be provided at a common location on a bracket to create a moment connection that resists rotation of a manifold (e.g., under pressure). In some examples, a one-piece bracket can be provided to reduce tolerance stack-up due to individual tolerances of multiple bracket pieces. Accordingly, bracket assemblies as described above and detailed further below can accommodate variabilities in alignment with manifold assemblies relative to an electronics enclosure.

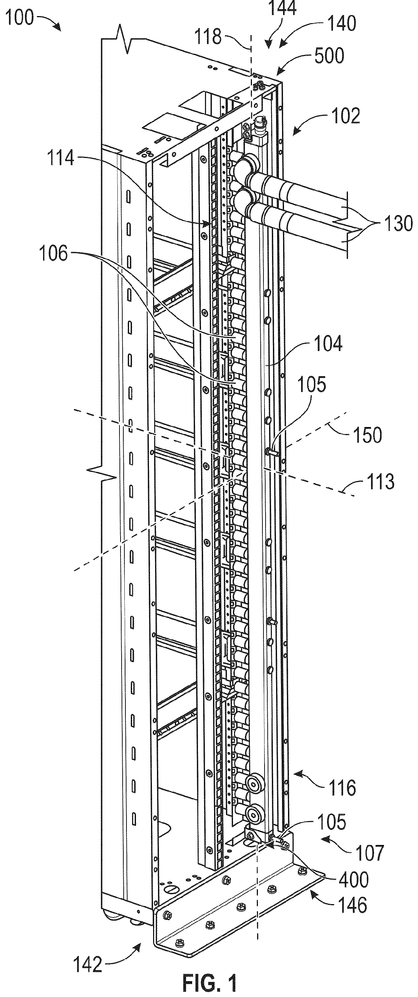

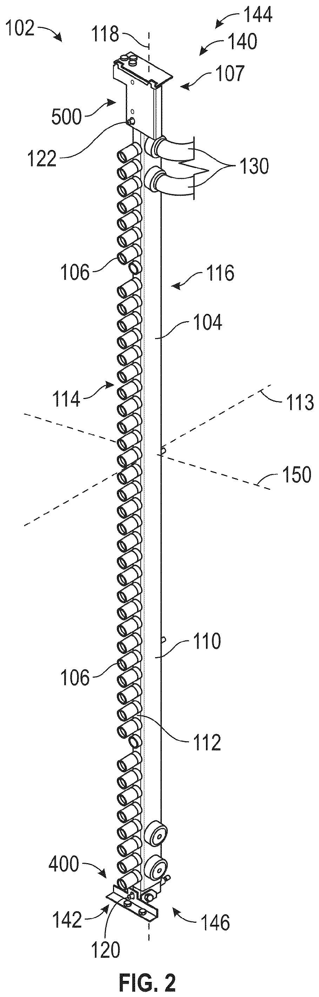

FIG. 1 illustrates an example electronics enclosure 100 (e.g., a server rack or an electronics rack) and a manifold mounting system that includes a manifold assembly 102 installed on the electronics enclosure 100. The electronics enclosure 100 can be configured a rack that defines a lateral direction between opposing lateral sides of the rack. As separately shown in FIG. 2, the manifold assembly 102 includes a manifold having a manifold tube 104 and a plurality of ports 106 (e.g., quick-connect couplings) that extends from the manifold tube 104. The manifold assembly 102 can be secured to the electronics enclosure 100 via a mounting assembly 107 of the manifold system that includes an upper bracket assembly 500 and a lower bracket assembly 400. In particular, the upper bracket assembly 500 can secure the manifold assembly 102 to an enclosure frame of the electronics enclosure 100 at an upper portion 140, and the lower bracket assembly 400 can secure the manifold assembly 102 to the enclosure frame at a lower portion 142. The manifold assembly 102 can be coupled to the electronics enclosure 100 to provide a path for coolant flow, to transfer heat away from electronics of the electronics enclosure 100. The ports 106 can extend from a front wall 112 of the manifold tube 104 in a depth direction parallel to an axis 113 (e.g., in a direction toward electrical equipment within the rack). In the illustrated example, the axis 113 extends between a front side 114 of the manifold assembly 102 and a rear side 116 of the manifold assembly 102.

A manifold tube can be sized and configured to distribute a flow of fluid through a rack, and to facilitate a mounting of a manifold assembly to a rack. In particular, the manifold tube 104 (and the manifold assembly 102) can be elongate in a first direction, parallel to an axis 118. The axis 118 can be a vertical axis (e.g., perpendicular to the axis 113), with the manifold assembly 102 being installed with the elongate direction oriented vertically when the manifold assembly 102 is mounted to a rack. For example, the axis 118 can extend in a direction between the upper portion 140 and the lower portion 142. In some examples, the axis 118 can extend between an upper distal end 144 (e.g., a first distal end) of the manifold assembly 102 and a lower distal end 146 (e.g., a second distal end) of the manifold assembly 102 opposite the upper distal end 144. In the illustrated example, the manifold tube 104 can define a rectangular cross-sectional area along a fluid flow path (e.g., the manifold tube 104 can be a square tube). In other examples, the manifold tube 104 can include other cross-sectional shapes, including cylindrical-shaped (e.g., with a circular cross-section), triangular-shaped, hexagonal-shaped, star-shaped, etc. A lateral axis 150 can extend in a lateral direction (e.g., perpendicular to both of the axis 113 and the axis 118). For example, the axis 150 can extend between a first lateral side of the manifold assembly 102 and a second lateral side of the manifold assembly 102.

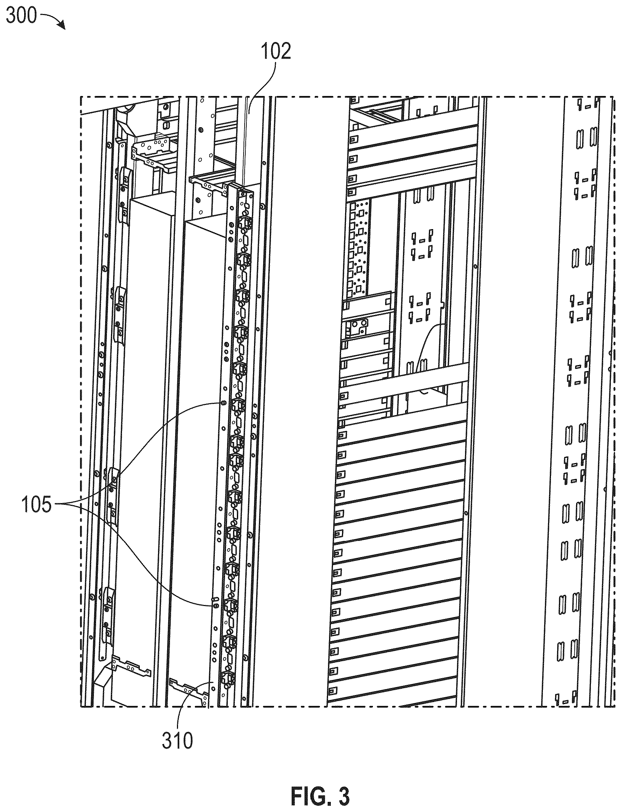

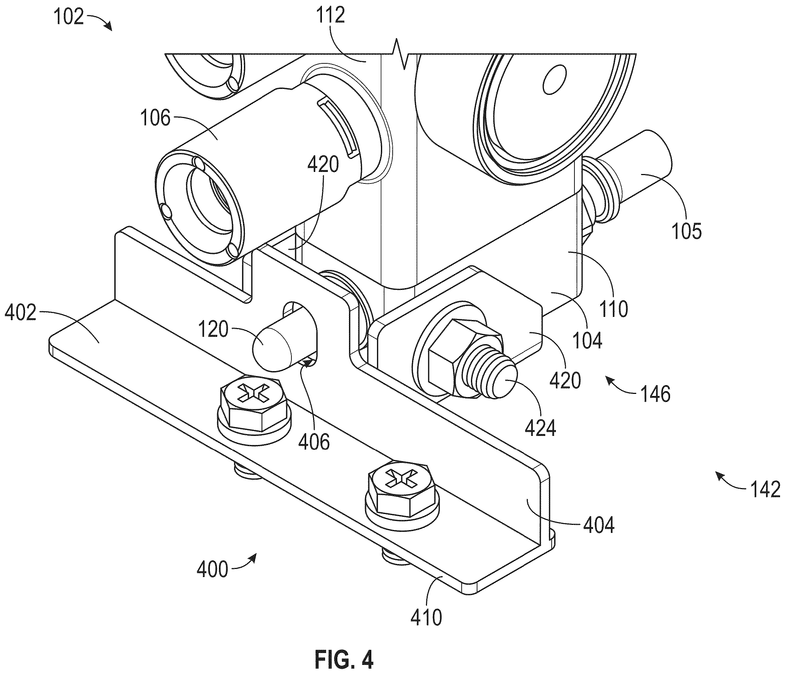

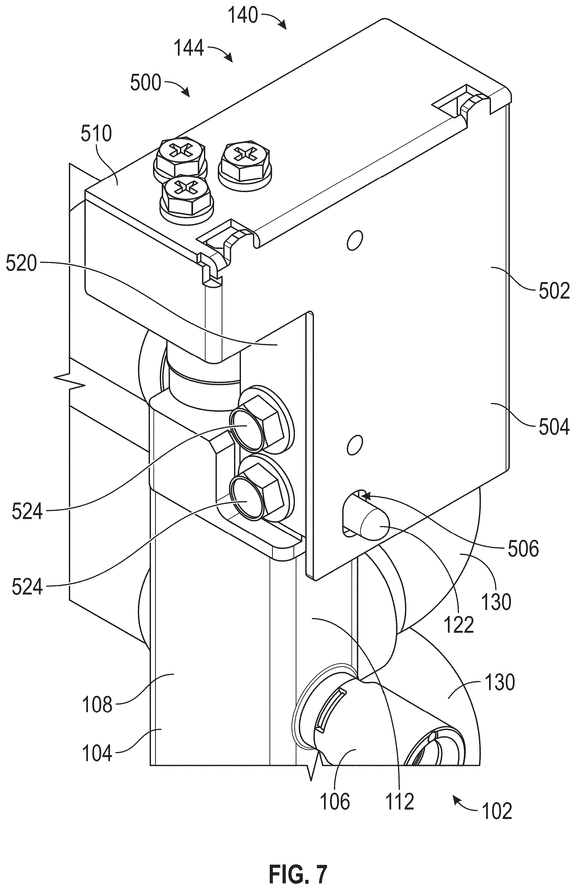

Manifold assemblies can define geometries and features for fixing a position of the manifold assembly relative to other features (e.g., a locating feature). In some examples, for example, protrusions can be provided along a manifold assembly that can be sized and positioned to interface with corresponding features of a structure (e.g., to be received into a corresponding aperture defined in the structure) to ensure that the manifold assembly is positioned in the desired position and orientation relative to the structure. In the illustrated example, the manifold assembly 102 includes backward-facing studs 105 (e.g., a rearward-facing guide pin, a second guide pin) that extend toward the rear side 116 in a direction opposite the depth direction. As discussed further with respect to FIG. 3, in some examples, the backward-facing studs 105 can be configured to be received into corresponding apertures of a chassis mounted to a rack. Accordingly, the engagement between the backward-facing studs 105 and the chassis can define a position and orientation of the manifold assembly 102 relative to the chassis in a vertical and depth direction (e.g., along the axis 118 and the axis 113). Further, as shown in FIG. 2, the manifold assembly 102 can include forward-facing guide pins 120, 122 (e.g., a first guide pin and as also shown in FIGS. 4 and 7, respectively) that extend toward the front side 114. In some examples, the forward-facing guide pins 120, 122 can be received into corresponding apertures of the respective bracket assemblies 400, 500. Accordingly, a lateral position of the manifold assembly 102 can be at least partially fixed relative to the bracket assemblies 400, 500 (e.g., and thus relative to the electronics enclosure 100).

As discussed above, the manifold assembly 102 can be secured in a vertical orientation within a server rack (e.g., with an elongate direction of the manifold assembly 102 parallel or substantially parallel to the axis 118 when the manifold assembly 102 is installed). In this orientation, the manifold assembly 102 can be connected to a fluid coolant loop, and the manifold assembly 102 can provide or receive a fluid coolant to and from electrical equipment (e.g., servers, batteries, network switches, storage disks, and drives, etc.) housed at different heights within a rack. In the illustrated example, the upper portion 140 is positioned at the upper distal end 144 and the lower portion 142 is positioned at the lower distal end 146. In the illustrated example, the manifold assembly 102 can include hosing 130 at the upper portion 140 to fluidly connect the manifold assembly 102 to a coolant loop (e.g., to either receive a fluid coolant at a "supply" or to expel a fluid coolant at a "return"). The plurality of ports 106 can distribute the received fluids to electrical equipment (e.g., a server tray) or receive fluids from the electrical equipment when aligned and connected with corresponding ports of the electrical equipment. In other examples, the manifold assembly 102 can include one or more of a supply hosing and a return hosing at the lower portion 142.

In the illustrated example, the plurality of ports 106 can be configured to matingly engage corresponding fluid ports of electrical equipment. In some examples, ports of a manifold assembly can be received into corresponding ports of electrical equipment (e.g., fluid ports of a manifold assembly can have a male configuration). In other examples, ports of a manifold assembly can receive corresponding fluid ports of electrical equipment (e.g., fluid ports of the manifold assembly can have a female configuration). The plurality of ports 106 can be quick-connect couplings. The ports 106 can be positioned to allow for a blind mate connection with ports of electrical equipment to be cooled when the manifold assembly 102 is mounted in a rack. The manifold assembly 102 can facilitate a toolless fluid connection between the ports 106 and corresponding ports of electrical equipment (e.g., without fasteners, weldment, adhesives, etc.) when the manifold assembly is mounted to a rack.

In some examples, a mounting system can provide selective constraint, fixing a position of a manifold relative to an electrical enclosure along at least one direction (e.g., one or more axes) while allowing the manifold to "float" (e.g., allowing for variable positioning of the manifold assembly relative to other alignment features) along one or more other axes. This selective constraint approach can provide proper alignment with reference features while accommodating tolerance variations in the enclosure, manifold, or other system components. In the illustrated example of FIG. 1, the upper bracket assembly 500 and the lower bracket assembly 400 are fixed to the electronics enclosure 100. The brackets can be fixed to the rack by extending fasteners through mounting flanges of the brackets and securing the fasteners to the rack structure. When the manifold assembly 102 is received into both of the bracket assemblies 400 and 500, a lateral position of the manifold assembly 102 is fixed (e.g., a position along a direction parallel to the axis 150), while allowing for a variable positioning of the manifold tube 104 along a height direction (e.g., a direction parallel to the axis 118) and along a depth direction (e.g., a direction parallel to the axis 113) before final tightening of fasteners that secure the manifold assembly to the brackets. The discussion below regarding FIGS. 4 and 7 provide further description and depiction for systems to fix a lateral position of a manifold assembly relative to brackets (e.g., and thus relative to a rack to which the brackets are mounted), according to some aspects of the present disclosure.

In addition to the bracket mounting system described above, in some examples, a position of a manifold assembly can be fixed in one or more directions (e.g., in a vertical direction and a depth direction) relative to a separate structure that is itself mounted to a rack of an electrical enclosure. For example, a chassis or other reference structure can be mounted to a rack, and the manifold assembly can include locating features (e.g., the backward-facing studs 105) that engage with corresponding features of the chassis to fix the manifold position in a vertical direction and a depth direction. Such a structure mounted to a rack can be variably positioned from rack to rack, due, for example, to tolerance stackup, variability in dimensioning, manufacturing tolerances, etc. In some examples, liquid ports of electrical equipment within a rack can be defined relative to a structure (e.g., a chassis) mounted to the rack, and it can be advantageous to also fix a position of ports of a manifold assembly relative to the structure in one or more directions as can at least partially guarantee an alignment between ports of the manifold assembly and ports of the electrical equipment.

For example, FIG. 3 illustrates a chassis 310 mounted to electronics rack 300 (e.g., an electronics rack similar or identical to the electronics enclosure 100 shown in FIG. 1). The chassis 310 can provide alignment features for aligning a manifold assembly (e.g., similar or identical to manifold assembly 102 shown in FIGS. 1 and 2) with the electronics rack 300 in one or both of a depth and a height direction. For example, as further shown, the manifold assembly 102 can be mounted within the electronics rack 300 and the backward-facing studs 105 can be received through corresponding apertures of the chassis 310. Accordingly, the position of the manifold assembly can be fixed in the vertical and depth directions. In some examples, the locating features (e.g., the backward-facing studs 105) can be provided at predetermined heights, for example, to mount the manifold assembly 102 at a desired height. Accordingly, the manifold assembly 102 can at least partially float relative to the electronics rack 300 to be positionable at a desired location. For example, referring back to FIG. 1, the upper distal end 144 and the lower distal end 146 can be free ends, although a general location of the manifold assembly 102 is established upon engaging with the server chassis. In some examples, ancillary mounting features, such as the upper bracket assembly 500 or the lower bracket assembly 400, can be provided to fine-tune or adjust a location of the manifold assembly 102 relative to the electronics enclosure 100 (e.g., along the directions parallel to axes A or C) after engaging with the server chassis. For example, the upper bracket assembly 500 or the lower bracket assembly 400 can provide local alignment with the manifold tube 104 while maintaining an installed configuration with a server chassis, an electronics enclosure, or other structures at data centers.

The illustrated manifold assembly 102 includes 42 ports 106, although a manifold assembly can include more ports or fewer ports in some examples. Further, a number of ports can correspond to a length of a manifold (e.g., ports can be spaced along the manifold at uniform distances). In some examples, a number of ports can correspond to a number of servers in a rack in which the manifold assembly is installed. For example, a server rack can include a predefined number of vertical shelves (e.g., slots) for housing electrical equipment having standard heights (e.g., 1 rack unit (U) or about 44 mm). A spacing of ports along a liquid manifold can correspond to a vertical spacing between shelves in the rack (e.g., ports of a manifold can be spaced apart from adjacent ports by about 1U or about 2U). This arrangement can allow the plurality of ports 106 to be at a fixed position relative to corresponding shelves of a server rack when the manifold assembly is mounted to the electronics enclosure. When electrical equipment (e.g., a server, a switch, a storage device, etc.) is mounted to the rack within a shelf (e.g., in an installed position), a fluid port of the electrical equipment can be positioned on the electrical equipment to matingly engage a fluid port of the manifold assembly corresponding to the shelf.

In some examples, fluid ports of a manifold can be dimensioned (e.g., spaced vertically) to accommodate particular rack configurations (e.g., non-standard or bespoke installations, installation heights defined by industry standards, national or international regulations, etc.). For example, In some examples, a manifold assembly can include one port for each 1U slot in a rack. In some examples, shelves of a rack can be configured to receive components having a height of 2U, and a manifold assembly can have 21 ports to correspond to each 2U slot within a rack. In some examples, a rack can include a mix of electronic components having different heights (e.g., a storage rack having 1U storage nodes and 2U or 4U disk shelves) and manifold assemblies can include a number of ports corresponding to a total number of electronic components in shelves of the rack, the ports being spaced to correspond to a spacing of the electronic components in the rack.

Further, a diameter of the fluid ports (e.g., a diameter of the quick connect fittings comprising the fluid ports) can be adapted for particular applications to achieve desired flow rates and pressure characteristics of cooling systems in which the liquid manifold is installed.

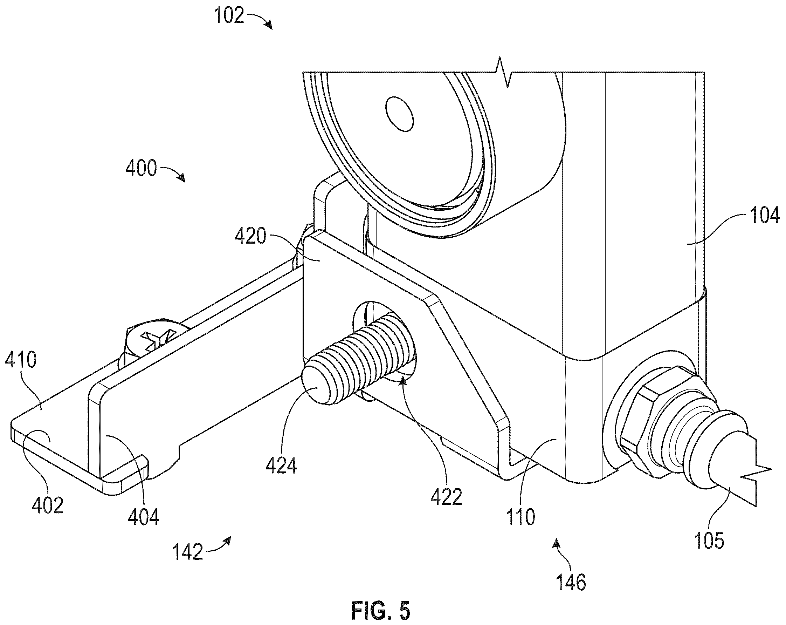

FIGS. 4 and 5 illustrate the lower bracket assembly 400 in greater details. The lower bracket assembly 400 can include a lower bracket 402 having various segments and flanges that extend in multiple directions to support the manifold assembly 102. In the illustrated example, the lower bracket 402 is a sheet metal bracket, as can be advantageously formed from a stamping and bending a single piece of sheet metal With specific reference to FIG. 4, the lower bracket 402 includes a lower traversal flange 404 that extends in a direction parallel to the axis 150 and defines a lower bracket slot 406 that extends along the axis 118. The lower bracket slot 406 can be sized to receive the lower guide pin 120 of the manifold assembly 102. The lower guide pin 120 can extend from the manifold tube 104 in a direction parallel to the axis 113. In particular, the lower guide pin 120 can be defined by a diameter that is smaller than a longitudinal length of the lower bracket slot 406. Thus, the lower guide pin 120 can translate within the lower bracket slot 406 in a direction parallel to the axis 118. Accordingly, the adjustable engagement between the lower guide pin 120 and the lower bracket slot 406 can support the manifold assembly 102 at a desired height relative to the electronics enclosure 100 (e.g., as shown in FIG. 1) or a lower mounting flange 410 of the lower bracket 402. In the illustrated example, the lower bracket slot 406 is shaped as a stadium or pill. However, in other examples, the lower bracket slot 406 can be shaped as an oblong, an oval, a rectangle, a rounded rectangle, a triangle, a square, a circle, a trapezoid, a polygon, or other elongated shapes. Further, a width of the bracket slot 406 (e.g., in a direction parallel to the axis 150) can be approximately equal to a diameter of the lower guide pin 120, and when the guide pin 120 is received through the bracket slot 406, a lateral movement of the manifold assembly 102 can be restricted.

In some examples, the lower bracket 402 can be mounted to the electronics enclosure 100 by extending clamping bolts through the lower mounting flange 410 and tightening the bolts. In some examples, mechanically coupling the lower bracket 402 to the electronics enclosure 100 can at least partially resist deflection of the manifold tube 104 during operation.

With continued reference to FIGS. 4 and 5, the lower bracket 402 includes lateral flanges 420 (e.g., side flanges) that extend in a direction parallel to the axis 113. In some examples, surfaces of the lateral flanges 420 can be parallel to a plane defined by the axes A and B. The lateral flanges 420 can define interfaces with the manifold tube 104. When the manifold tube 104 is received into the lower bracket 402 between the lateral flanges 420, the lateral flanges 420 can further fix a lateral position of the manifold tube 104. In some examples, a lower fastener 424 can extend through the lateral flanges 420 and lateral walls 108, 110 of the manifold tube 104 (e.g., the lateral wall 108 shown in FIG. 7) to secure the lower bracket 402 to the manifold tube 104. In some examples, the lower fastener 424 can extend entirely through the manifold tube 104, passing through the lateral wall 110, through an interior of the manifold tube 104, and through the lateral wall 108 opposite the lateral wall 110. This through-bolt configuration can provide advantages in force distribution and resistance to rotation, as the fastener engages both lateral sides of the manifold tube 104 simultaneously.

As shown in FIG. 5, the lateral flanges 420 can include a lower fastener aperture 422 (e.g., an oversized clearance hole) that is sized to receive the lower fastener 424. The lower fastener aperture 422 can be defined by a diameter that is greater than a diameter of the lower fastener 424. Due to the oversized shape of the lower fastener aperture 422, the lower fastener 424 can translate within the lower fastener aperture 422 in a direction parallel to the axis 113 or the axis 118, with variations in positions of the manifold assembly 102 relative to a depth or height along the electronics enclosure 100. Accordingly, the adjustable engagement between the lower fastener 424 and the lower fastener aperture 422 can support the manifold assembly 102 at a desired height or depth relative to the electronics enclosure 100 (e.g., as shown in FIG. 1) or the lower mounting flange 410. In some examples, the depth adjustment in the direction parallel to the axis 113 can provide a more accurate alignment between the ports 106 and corresponding ports of an electrical equipment, such as can prevent jamming of the ports 106 and the corresponding ports of the electrical equipment due to over-proximity. When the manifold tube 104 is arranged at a desired position relative to the lower bracket 402, a bolt can be tightened on the lower fastener 424 to secure the lower bracket 402 to the manifold tube 104. Tightening the lower fastener 424 can provide clamping forces that clamp the manifold tube 104 between the lateral flanges 420, with each of the lateral flanges 420 engaging one of the lateral walls 108, 110 of the manifold tube 104.

In some examples, a single fastener can extend (entirely) through the manifold tube 104 in a direction parallel to the axis 150 from one of the lateral walls 108, 110 of the manifold tube 104 to an opposite one of the lateral walls 108, 110 of the manifold tube 104. When the ports 106 of the manifold assembly 102 are connected with corresponding ports of electrical equipment, fluid pressure forces can act on the quick-connect couplings, creating forces that tend to separate the couplings and moments that tend to rotate the manifold tube 104. A fastener extending entirely through the manifold tube 104 can create reaction forces on both lateral sides of the manifold that resist such rotation, producing a more uniform and evenly distributed reaction force, for example, compared to a bracket assembly that provides a single-sided attachment approach (e.g., where fasteners attach from only one lateral side). Accordingly, the arrangement of the lower fastener 424 through the manifold tube 104 can aid in preventing rotation of the manifold tube 104 relative to the electronics enclosure 100 or electrical equipment under load. In some examples, the illustrated arrangement of the lower fastener 424 can enhance an installation or assembly process of the manifold assembly 102 to the electronics enclosure 100, as the through-bolt design can eliminate the need for pre-assembled bracket components on the manifold tube 104.

Further, in some examples, the through-bolt configuration can provide improved mechanical stiffness at the interface between the lower bracket 402 and the manifold tube 104 compared to fasteners received into threaded bosses. When the lower fastener 424 extends entirely through the manifold tube 104, tightening the lower fastener 424 can create clamping forces that compress the manifold tube 104 between the lateral flanges 420 of the lower bracket 402. This clamping action can create a rigid connection that resists movement in multiple directions. In contrast, fasteners received into threaded bosses on a single side of a manifold may provide less resistance to rotation, as the manifold could potentially rotate about the attachment points under operational loads.

Further, while the illustrated example shows one lower fastener extending through the manifold tube 104, a greater number of fasteners can be provided (e.g., two, three, four, five, etc.) for clamping the lower bracket 402 to the manifold tube 104. In some examples, the diameter of the lower fastener aperture 422 can be at least 10% greater than the diameter of the lower fastener 424, or at least 30% greater than the diameter of the lower fastener 424, or at least 50% greater than the diameter of the lower fastener 424, or at least 70% greater than the diameter of the lower fastener 424, or at least 90% greater than the diameter of the lower fastener 424, or at least 100% greater than the diameter of the lower fastener 424, or at least 150% greater than the diameter of the lower fastener 424, or at least 200% greater than the diameter of the lower fastener 424.

In some examples, a diameter of the lower fastener aperture 422 can be substantially similar to the longitudinal length of the lower bracket slot 406 (e.g., as shown in FIG. 4). In some examples, a diameter of the lower fastener aperture 422 can be greater than the longitudinal length of the lower bracket slot 406. In some examples, a diameter of the lower fastener aperture 422 can be smaller than the longitudinal length of the lower bracket slot 406. In some examples, a shape of the lower fastener aperture 422 need not be circular as illustrated in FIG. 5 but can be differently shaped, including ovularly, rectangularly, squarely, polygonally, etc. In some examples, the lower fastener aperture 422 can include different dimensions in directions parallel to the axes A and B, such that a maximum range of translation along the direction parallel to the axis 118 differs from the axis 113.

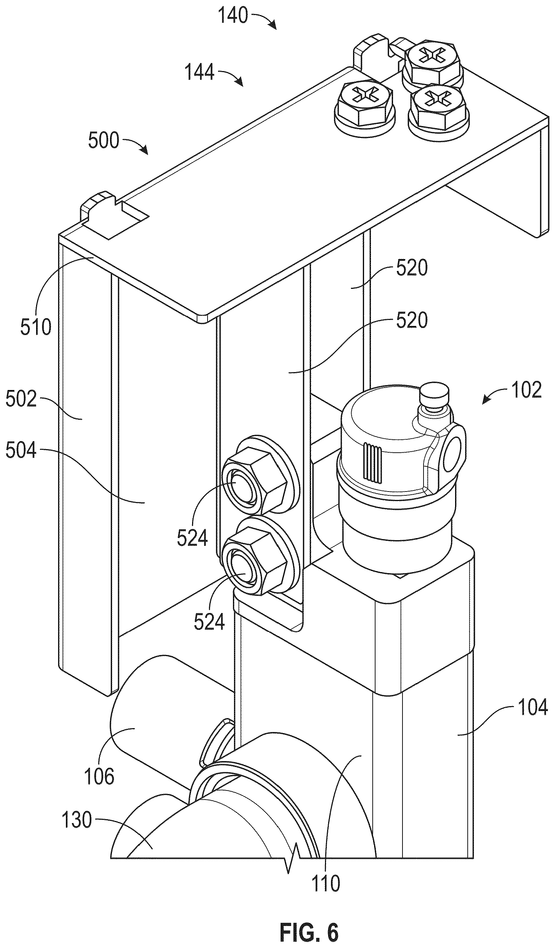

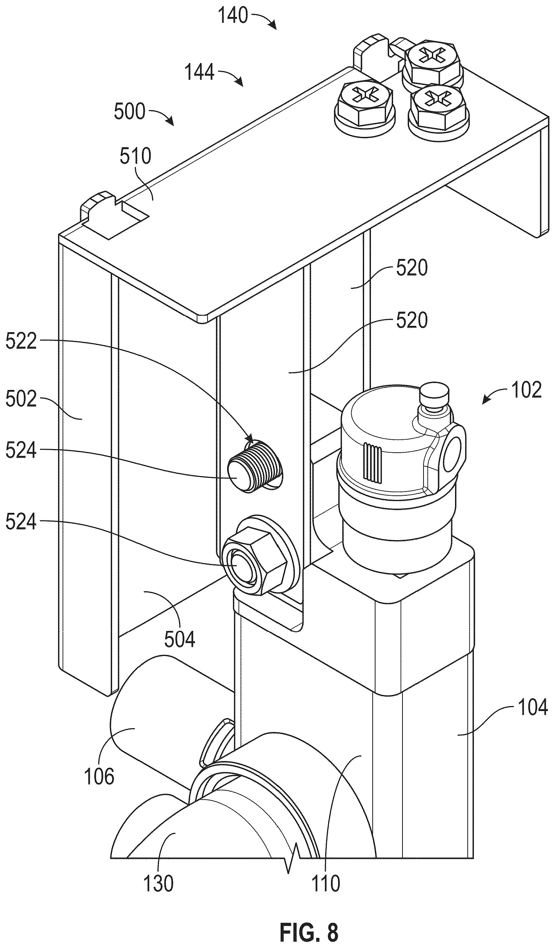

FIGS. 6-8 illustrate the upper bracket assembly 500 in greater details. The upper bracket assembly 500 includes similar features as included in the lower bracket assembly 400 of FIGS. 4 and 5, and features of the upper bracket assembly 500 described below include reference numbers that are generally similar to those used in FIGS. 4 and 5. The discussion above applies to similar named or numbered items below unless, otherwise noted or required. For example, the upper bracket assembly 500 includes an upper bracket 502 and an upper bracket slot 506 of an upper transversal flange 504 that engages with the upper guide pin 122 of the manifold assembly 102, just as the lower bracket assembly 400 includes the lower bracket 402 and the lower bracket slot 406 that engages with the lower guide pin 120 of the manifold assembly 102. Further, the upper bracket 502 includes an upper mounting flange 510 that is configured to engage with the electronics enclosure 100 (e.g., as shown in FIG. 1), just as the lower bracket 402 includes the lower mounting flange 410 that is configured to engage with the electronics enclosure 100.

In some examples, the upper bracket assembly 500 and the lower bracket assembly 400 differ in some regards, including with regard to clamp configurations through the manifold tube 104. In particular, the upper bracket assembly 500 includes two upper fasteners 524 that are vertically spaced apart in a direction parallel to the axis 118. The upper bracket assembly 500 further includes two upper lateral flanges 520 that are spaced apart in a direction parallel to the axis 150, and each of the upper lateral flanges 520 defines two upper fastener apertures 522 configured to receive the corresponding two upper fasteners 524.

In some examples, providing additional fastener(s) at the upper bracket location can bolster a structural connection at an interface between the upper bracket 502 and manifold tube 104. For example, two fasteners spaced apart along a height direction can create a moment connection that provides additional moment reaction forces to counter the pressure forces exerted by fluid flow through the manifold and the forces acting on the quick-connect couplings. The dual-bolt configuration can create reaction forces at two vertically-spaced locations, which can resist rotation of the manifold about a single attachment point at a greater degree than a single fastener. The vertically-spaced arrangement of the two upper fasteners 524 can provide a moment arm that provides enhanced resistance to rotational forces compared to a single fastener configuration. Accordingly, a mechanical stress experienced by the manifold tube 104 can be redistributed and an overall deflection of the manifold tube 104 at the upper portion 140 can be reduced. Providing two vertically-spaced fasteners for a bracket holding a manifold assembly can thus create a moment connection for resisting rotation of the manifold relative to the bracket under operational loads such as fluid pressure and spring forces from quick-connect couplings.

While the illustrated example shows two upper fasteners extending through the manifold tube 104, a greater number of fasteners (e.g., three, four, five, etc.) or a fewer number of fasteners (e.g., one) can be provided for clamping the upper bracket 502 to the manifold tube 104. In some examples, incorporating fasteners that extend an entire way through the lateral walls 108, 110 of the manifold tube 104 can contribute to achieving static equilibrium of the manifold assembly 102 by providing balanced reaction forces on both lateral sides of the manifold. The through-bolt design can be particularly advantageous at the upper portion 140 of the manifold assembly 102, where deflection under load may be greater due to the cantilevered nature of the manifold tube 104 extending downward from the upper mounting point at the upper distal end 144. The dual through-bolt configuration at the upper bracket 502, with the two upper fasteners 524 being vertically spaced apart, can provide greater resistance to rotation compared to single-sided attachment approaches (where fasteners attach from only one lateral side) or single fastener configurations. The vertically-spaced dual through-bolt arrangement can create a moment connection that resists rotational forces in the manifold assembly 102.

In some examples, the single-piece construction of the lower bracket 402 and the upper bracket 502 can provide advantages over multi-piece bracket assemblies. For example, brackets formed from a single piece of sheet metal can eliminate tolerance stack-up that may result from assembling multiple separate bracket components together. Each separate component in a multi-piece bracket assembly can contribute its own dimensional variations, and these variations can accumulate to create larger overall tolerances. By forming a bracket as a single integral piece, such as the lower bracket 402 and the upper bracket 502, the number of tolerance-contributing components can be reduced, potentially improving the precision of manifold positioning. Additionally, single-piece brackets can simplify the assembly process by eliminating the need to pre-assemble multiple bracket components together or to pre-assemble bracket components to the manifold before installing the manifold into a rack, which can reduce assembly time and the potential for assembly errors. The single-piece bracket design can allow the bracket to be fixed to the electronics enclosure 100 independently, and the manifold assembly 102 can then be positioned and secured to the bracket without requiring pre-assembly of bracket components to the manifold.

In some implementations, devices or systems disclosed herein can be utilized or installed using methods embodying aspects of the disclosed technology. Correspondingly, description herein of particular features or capabilities of a device or system is generally intended to inherently include disclosure of a method of using such features for intended purposes and of implementing such capabilities. Similarly, express discussion of any method of using a particular device or system, unless otherwise indicated or limited, is intended to inherently include disclosure, as embodiments of the disclosed technology, of the utilized features and implemented capabilities of such device or system. For example, aspects of the disclosed technology can include the manufacture or installation of the various manifold assemblies discussed above, as well as operation of a cooling system that includes such assemblies.

### FURTHER EXAMPLES

Example 1. A manifold mounting system for an electronics rack, the manifold mounting system comprising: a manifold assembly including: a manifold tube that extends between an upper end of the manifold assembly and a lower end of the manifold assembly along a longitudinal axis 118nd includes a first wall and a second wall opposite the first wall; a plurality of ports extending from a third wall of the manifold tube; a guide pin extending from the third wall; and a mounting assembly including: a bracket for securing the manifold assembly to the electronics rack, the bracket including: a front flange defining a slot configured to receive the guide pin; opposing side flanges each including at least one aperture; and at least one fastener extending through the first wall and the second wall in a mounted configuration, the at least one fastener extending through the at least one aperture in each of the opposing side flanges.

Example 2. The manifold mounting system of Example 1, wherein the bracket includes two fasteners that are vertically spaced apart in a direction parallel to the longitudinal axis.

Example 3. The manifold mounting system of Example 1, wherein the bracket secures the manifold assembly to the electronics rack at the upper end or the lower end.

Example 4. The manifold mounting system of Example 1, wherein the manifold assembly further includes: a second guide pin that extends from a fourth wall of the manifold tube opposite the third wall, in the mounted configuration of the manifold assembly, the second guide pin engaging with a chassis that is mounted to the electronics rack.

Example 5. The manifold mounting system of Example 1, wherein, in the mounted configuration, each of the opposing side flanges engages one of the first wall or the second wall to clamp the manifold tube between the opposing side flanges.

Example 6. The manifold mounting system of Example 1, wherein a length of the slot is at least 10% greater than a diameter of the guide pin.

Example 7. The manifold mounting system of Example 1, wherein a diameter of the at least one aperture of each of the opposing side flanges is at least 10% greater than a diameter of the at least one fastener.

Example 8. The manifold mounting system of Example 1, wherein the guide pin is a first guide pin, the bracket is a first bracket at one of the upper end or the lower end, the front flange is a first front flange including a first slot, the opposing side flanges are opposing first side flanges, the manifold assembly further includes a second guide pin extending from the third wall, and the mounting assembly further including: a second bracket at the other one of the upper end or the lower end, the second bracket comprising: a second front flange including a second slot for receiving the second guide pin; opposing second side flanges each defining at least one aperture; and a second fastener extending the at least one aperture of each of the opposing second side flanges and through the manifold tube from the first wall to the second wall in the mounted configuration.

Example 9. The manifold mounting system of Example 1, wherein the bracket is formed as a single piece.

Example 10. A method of mounting a manifold to an electronics rack, the method comprising: providing a manifold assembly including a manifold tube that extends between an upper end and a lower end along a longitudinal axis, the manifold tube including a first wall and a second wall opposite the first wall, a plurality of ports extending from a third wall of the manifold tube, and a guide pin extending from the third wall; providing a bracket including a front flange having a slot, and opposing side flanges each including at least one aperture; inserting the guide pin into the slot of the front flange; positioning the opposing side flanges adjacent to the first wall and the second wall of the manifold tube; and inserting at least one fastener through the at least one aperture of each of the opposing side flanges and through the manifold tube from the first wall to the second wall to secure the manifold to the bracket.

Example 11. The method of Example 10, further comprising: adjusting a position of the manifold tube relative to the bracket before tightening the at least one fastener.

Example 12. The method of Example 10, wherein inserting the at least one fastener includes inserting two fasteners that are vertically spaced apart in a direction parallel to the longitudinal axis.

Example 13. The method of Example 10, wherein positioning the opposing side flanges includes clamping the manifold tube between the opposing side flanges.

Example 14. The method of Example 10, wherein providing the bracket includes defining one or more of: a length of the slot being at least 10% greater than a diameter of the guide pin; or a diameter of the at least one aperture of each of the opposing side flanges being at least 10% greater than a diameter of the at least one fastener.

Example 15. The method of Example 10, further comprising: providing a second bracket at an opposite end of the manifold tube from the bracket, the second bracket including a second front flange having a second slot and opposing second side flanges each including at least one second aperture; inserting a second guide pin extending from the third wall of the manifold tube into the second slot of the second front flange; positioning the opposing second side flanges adjacent to the first wall and the second wall of the manifold tube; and inserting at least one second fastener through the at least one second aperture of each of the opposing second side flanges and through the manifold tube from the first wall to the second wall to secure the manifold to the second bracket.

Example 16. A mounting assembly for securing a manifold to an electronics rack, the mounting assembly comprising: a first bracket configured to secure a first end of the manifold to the electronics rack, the first bracket including: a first plurality of flanges including a first slot for receiving a first guide pin of the manifold and a first plurality of apertures; and at least two fasteners extending through the first plurality of apertures and through the manifold, the at least two fasteners being vertically spaced apart; and a second bracket configured to secure a second end of the manifold to the electronics rack, the second bracket including: a second front flange including a second slot for receiving a second guide pin of the manifold and a second plurality of apertures; and at least one fastener extending through the second plurality of apertures and through the manifold.

Example 17. The mounting assembly of Example 16, wherein the first bracket is configured to secure an upper end of the manifold and the second bracket is configured to secure a lower end of the manifold.

Example 18. The mounting assembly of Example 16, wherein each of the first bracket and the second bracket is formed as a single piece.

Example 19. The mounting assembly of Example 16, wherein a diameter of the first plurality of apertures or the second plurality of apertures is greater than a diameter of the corresponding fastener to allow positional adjustment of the manifold relative to the first bracket or the second bracket.

Example 20. The mounting assembly of Example 16, wherein when the manifold is secured to the electronics rack, the at least two fasteners of the first bracket extends through the first plurality of apertures create a moment connection that resists rotation of the manifold.

The previous description of the disclosed embodiments is provided to enable any person skilled in the art to make or use the disclosed technology. Various modifications to these embodiments will be readily apparent to those skilled in the art, and the generic principles defined herein may be applied to other embodiments without departing from the spirit or scope of the disclosed technology. Thus, the disclosed technology is not intended to be limited to the embodiments shown herein but is to be accorded the widest scope consistent with the principles and novel features disclosed herein.

Features which are described in the context of separate embodiments may also be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. One or more feature(s) or components of the device(s) and system(s) described may be incorporated into/used in corresponding methods and vice versa.

Unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "only one of," or "exactly one of." For example, a list of "only one of A, B, or C" indicates options of: A, but not B and C; B, but not A and C; and C, but not A and B. In contrast, a list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more A, one or more B, and one or more C. Similarly, a list preceded by "a plurality of" (and variations thereon) and including "or" to separate listed elements indicates options of one or more of each of multiple of the listed elements. For example, the phrases "a plurality of A, B, or C" and "two or more of A, B, or C" indicate options of: one or more A and one or more B; one or more B and one or more C; one or more A and one or more C; and one or more A, one or more B, and one or more C.

Unless otherwise specifically indicated, ordinal numbers are used herein for convenience of reference, based generally on the order in which particular components are presented in the relevant part of the disclosure. In this regard, for example, designations such as "first," "second," etc., generally indicate only the order in which a thus-labeled component is introduced for discussion and generally do not indicate or require a particular spatial, functional, temporal, or structural primacy or order. Relatedly, similar or identical components may be referred to with different ordinal numbers in different contexts.

Also as used herein, unless otherwise limited or defined, the terms "about" and "approximately" refer to a range of values ± 5% of the numeric value that the term precedes. As a default the terms "about" and "approximately" are inclusive to the endpoints of the relevant range, but disclosure of ranges exclusive to the endpoints is also intended.

Also as used herein, unless otherwise limited or defined, "integral" and derivatives thereof (e.g., "integrally") describe elements that are manufacture as a single piece without fasteners, adhesive, or the like to secure separate components together. For example, an element stamped as a single-piece component from a single piece of sheet metal, without rivets, screws, or adhesive to hold separately formed pieces together is an integral (and integrally formed) element. In contrast, an element formed from multiple pieces that are separately formed initially then later connected together, is not an integral (or integrally formed) element.

Also as used herein, unless otherwise defined or limited, the term "lateral" refers to a direction that does not extend in parallel with a reference direction. A feature that extends in a lateral direction relative to a reference direction thus extends in a direction, at least a component of which is not parallel to the reference direction. In some examples, a lateral direction can be a radial or other perpendicular direction relative to a reference direction.

Also as used herein, unless otherwise defined or limited, the term "substantially identical" indicates components or features that are manufactured to the same specifications (e.g., as may specify materials, nominal dimensions, permitted tolerances, etc.), using the same manufacturing techniques. For example, multiple parts stamped from the same material, to the same tolerances, using the same mold may be considered to be substantially identical, even though the precise dimensions of each of the parts may vary from the others.

As used herein, unless otherwise limited or defined, "substantially perpendicular" indicates a direction that is within ± 12 degrees of perpendicular a reference direction (e.g., within ± 6 degrees or ± 3 degrees), inclusive.

As used herein, unless otherwise defined or limited, two components that are described herein as "aligned", relative to a reference direction, are each at least partly located along a common reference line in the reference direction. Thus, for example, components that are described as "vertically aligned" are aligned along a common vertical line.

Also as used herein, unless otherwise defined or limited, directional terms are used for convenience of reference for discussion of particular figures or examples or to indicate spatial relationships relative to particular other components or context, but are not intended to indicate absolute orientation. For example, references to downward, forward, or other directions, or to top, rear, or other positions (or features) may be used to discuss aspects of a particular example or figure, but do not necessarily require similar orientation or geometry in all installations or configurations.

As used herein, unless otherwise specified or limited, the term "L-shaped" specifies a shape that includes a base portion, with a leg or stem portion extending substantially perpendicular to the base portion from one end thereof. In different examples, an "L-shaped" member can include leg or stem portions that extend from the corresponding base portion with or without curved, chamfered, or otherwise non-square connecting junctions.

Also as used herein, unless otherwise limited, a "fluid port" means any feature that provides a transition into or out of a particular system along a fluid particular flow path. Thus, for example, a fluid port can include simple openings in structures that are configured for fluid flow, or more complex mechanisms such as fluid couplings (e.g., a quick-connect coupling). A fluid port can include one or more features or one or more components (e.g., may be an assembly of multiple parts) that can provide the transition in or out of a particular system. For example, a fluid port can include a fitting (e.g., a quick-connect coupling) and corresponding features (e.g., an inlet aperture) on a system (e.g., a pipe or manifold) in communication with the fitting.

Also as used herein, the term "datum" refers to a reference geometry that establishes a known dimension between components. For example, a datum plane can be a plane with a known (e.g., a predefined) depth relative to another plane or component. A datum mounting feature can have a fixed offset from ports of a manifold assembly, for example, such that the ports are positioned at a known position in a three-dimensional space relative to a rack when the datum mounting feature is received into a corresponding feature of a rack. In some examples, a datum can define a fixed starting point relative to which dimensions are defined for a component.

## Claims

1. A manifold mounting system for an electronics rack, the manifold mounting system comprising:
a manifold assembly including:
a manifold tube that extends between an upper end of the manifold assembly and a lower end of the manifold assembly along a longitudinal axis and includes a first wall and a second wall opposite the first wall;
a plurality of ports extending from a third wall of the manifold tube;
a guide pin extending from the third wall; and
a mounting assembly including:
a bracket for securing the manifold assembly to the electronics rack, the bracket including:
a front flange defining a slot configured to receive the guide pin;
opposing side flanges each including at least one aperture; and
at least one fastener extending through the first wall and the second wall in a mounted configuration, the at least one fastener extending through the at least one aperture in each of the opposing side flanges.

2. The manifold mounting system of claim 1, wherein the bracket includes two fasteners that are vertically spaced apart in a direction parallel to the longitudinal axis.

3. The manifold mounting system of claim 1 or claim 2, wherein the bracket secures the manifold assembly to the electronics rack at the upper end or the lower end.

4. The manifold mounting system of claim 1, claim 2 or claim 3, wherein the manifold assembly further includes:
a second guide pin that extends from a fourth wall of the manifold tube opposite the third wall; and
in the mounted configuration of the manifold assembly, the second guide pin engaging with a chassis that is mounted to the electronics rack.

5. The manifold mounting system of claim 1 or of any of claims 2 to 4, wherein, in the mounted configuration, each of the opposing side flanges engages one of the first wall or the second wall to clamp the manifold tube between the opposing side flanges.

6. The manifold mounting system of claim 1 or of any of claims 2 to 5, wherein a length of the slot is at least 10% greater than a diameter of the guide pin.

7. The manifold mounting system of claim 1 or of any of claim 2 to 6, wherein a diameter of the at least one aperture of each of the opposing side flanges is at least 10% greater than a diameter of the at least one fastener.

8. The manifold mounting system of claim 1 or of any of claims 2 to 7, wherein the guide pin is a first guide pin, the bracket is a first bracket at one of the upper end or the lower end, the front flange is a first front flange including a first slot, the opposing side flanges are opposing first side flanges, the manifold assembly further includes a second guide pin extending from the third wall, and the mounting assembly further including:
a second bracket at the other one of the upper end or the lower end, the second bracket comprising:
a second front flange including a second slot for receiving the second guide pin;
opposing second side flanges each defining at least one aperture; and
a second fastener extending the at least one aperture of each of the opposing second side flanges and through the manifold tube from the first wall to the second wall in the mounted configuration.

9. The manifold mounting system of claim 1 or of any of claims 2 to 8, wherein the bracket is formed as a single piece.

10. A method of mounting a manifold to an electronics rack, the method comprising:
providing a manifold assembly including a manifold tube that extends between an upper end and a lower end along a longitudinal axis, the manifold tube including a first wall and a second wall opposite the first wall, a plurality of ports extending from a third wall of the manifold tube, and a guide pin extending from the third wall;
providing a bracket including a front flange having a slot, and opposing side flanges each including at least one aperture;
inserting the guide pin into the slot of the front flange;
positioning the opposing side flanges adjacent to the first wall and the second wall of the manifold tube; and
inserting at least one fastener through the at least one aperture of each of the opposing side flanges and through the manifold tube from the first wall to the second wall to secure the manifold to the bracket.

11. The method of claim 10, further comprising:
adjusting a position of the manifold tube relative to the bracket before tightening the at least one fastener.

12. The method of claim 10 or claim 11, wherein inserting the at least one fastener includes inserting two fasteners that are vertically spaced apart in a direction parallel to the longitudinal axis.

13. The method of claim 10, claim 11 or claim 12, wherein positioning the opposing side flanges includes clamping the manifold tube between the opposing side flanges.

14. The method of claim 10 or of any of claims 11 to 13, wherein providing the bracket includes defining one or more of:
a length of the slot being at least 10% greater than a diameter of the guide pin; or
a diameter of the at least one aperture of each of the opposing side flanges being at least 10% greater than a diameter of the at least one fastener.

15. The method of claim 10 or of any of claims 11 to 14, further comprising:
providing a second bracket at an opposite end of the manifold tube from the bracket, the second bracket including a second front flange having a second slot and opposing second side flanges each including at least one second aperture;
inserting a second guide pin extending from the third wall of the manifold tube into the second slot of the second front flange;
positioning the opposing second side flanges adjacent to the first wall and the second wall of the manifold tube; and
inserting at least one second fastener through the at least one second aperture of each of the opposing second side flanges and through the manifold tube from the first wall to the second wall to secure the manifold to the second bracket.
